# EUROPÄISCHE PATENTANMELDUNG

(11) **EP 4 495 989 A1**
(43) Veröffentlichungstag der Anmeldung: **22.01.2025**
(21) Anmeldenummer: 23186939.7
(22) Anmeldetag: 21.07.2023
(51) Int. Cl.: H01L 23/00, H01L 23/498, H01L 23/66, H01L 25/07

(54) **HALBLEITERANORDNUNG MIT EINEM HALBLEITERELEMENT**

(71) Anmelder: Siemens Aktiengesellschaft, 80333 München (DE)
(72) Erfinder: Hüttner, Rainer, 96050 Bamberg (DE); Lorz, Roland, 91341 Röttenbach (DE); Ye, Yijun, 91056 Erlangen (DE); Kecskemeti, Gabor, 91056 Erlangen (DE)
(74) Vertreter: Siemens Patent Attorneys

(57) **Zusammenfassung**

Die Erfindung betrifft eine Halbleiteranordnung (2) mit einem Halbleiterelement (4), welches auf einem Trägerelement (6) angeordnet ist, wobei das Halbleiterelement (4) auf einer dem Trägerelement (6) abgewandten Seite einen ersten Lastkontakt (8) und einen zweiten Lastkontakt (10) aufweist, wobei das Trägerelement (6) eine erste Leiterstruktur (12) und eine von der ersten Leiterstruktur (12) elektrisch isoliert angeordnete zweite Leiterstruktur (14) umfasst. Um, im Vergleich zum Stand der Technik, eine verbesserte Verdrahtung anzugeben wird vorgeschlagen, dass die zweite Leiterstruktur (14) zwischen dem Halbleiterelement (4) und der ersten Leiterstruktur (12) angeordnet ist, wobei der erste Lastkontakt (8) zwischen dem zweiten Lastkontakt (10) und der zweiten Leiterstruktur (14) angeordnet ist, wobei der erste Lastkontakt (8) über zumindest ein erstes Verdrahtungselement (16) mit der ersten Leiterstruktur (12) verbunden ist, wobei der zweite Lastkontakt (10) über zumindest ein zweites Verdrahtungselement (18) mit der zweiten Leiterstruktur (14) verbunden ist, wobei das zweite Verdrahtungselement (18) das erste Verdrahtungselement (16) zumindest teilweise überspannend angeordnet ist.

## Beschreibung

Die Erfindung betrifft eine Halbleiteranordnung mit einem Halbleiterelement.

Darüber hinaus betrifft die Erfindung einen Stromrichter mit mindestens einem derartigen Halbleiterelement.

Überdies betrifft die Erfindung ein Verfahren zur Herstellung einer Halbleiteranordnung.

Eine derartige Halbleiteranordnung kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die im Halbleitermodul zum Einsatz kommenden Halbleiterelemente sind unter anderem Transistoren, Triacs, Thyristoren oder Dioden.

Üblicherweise werden die Halbleiterelemente über Bonddrähte auf einem Substrat kontaktiert, was zu einer zusätzlichen Induktivität in der Halbleiteranordnung führt. Aufgrund steigernder Schaltgeschwindigkeiten in derartigen Halbleiteranordnungen vergrößern sich die Auswirkungen parasitärer Induktivitäten zunehmend. Insbesondere bei Verwendung von Halbleiterelementen mit breiter Bandlücke, z.B. GaN- oder SiC- Halbleiterelementen, ist es geboten, parasitäre Induktivität beim Layout zu minimieren.

Die Patentschrift US 11,183,440 B2 beschreibt Leistungsmodule mit niedriger Induktivität für ultraschnelle Halbleiter-Leistungsschaltgeräte mit breiter Bandlücke.

Die Offenlegungsschrift EP 4 120 341 A1 betrifft eine Halbleiteranordnung mit einem Halbleiterelement, einem Substrat und Bondverbindungsmitteln. Um, im Vergleich zum Stand der Technik, eine verbesserte Verdrahtung zu erreichen, wird vorgeschlagen, dass das Halbleiterelement, insbesondere stoffschlüssig, mit dem Substrat verbunden ist, wobei das Halbleiterelement auf einer dem Substrat abgewandten Seite zumindest eine Kontaktfläche aufweist, wobei zumindest eine Kontaktfläche des Halbleiterelements über zumindest ein erstes Bondverbindungsmittel mit dem Substrat verbunden ist, wobei das zumindest eine erste Bondverbindungsmittel auf der Kontaktfläche zumindest einen ersten Wedgebondkontakt ausbildet, welcher zwischen einem ersten Loop und einem zweiten Loop des zumindest einen ersten Bondverbindungsmittels angeordnet ist, wobei der erste Loop ein erstes Maximum und der zweite Loop ein zweites Maximum aufweist, wobei ein erster Quer-Loop eines zweiten Bondverbindungsmittels oberhalb des ersten Wedgebondkontakts und zwischen dem ersten Maximum des ersten Loops und dem zweiten Maximum des zweiten Loops verlaufend angeordnet ist.

Vor diesem Hintergrund liegt der Erfindung die Aufgabe zugrunde, eine Halbleiteranordnung anzugeben, welche, im Vergleich zum Stand der Technik, eine verbesserte Verdrahtung aufweist.

Die Aufgabe wird erfindungsgemäß gelöst durch eine Halbleiteranordnung mit einem Halbleiterelement, welches auf einem Trägerelement angeordnet ist, wobei das Halbleiterelement auf einer dem Trägerelement abgewandten Seite einen ersten Lastkontakt und einen zweiten Lastkontakt aufweist, wobei das Trägerelement eine erste Leiterstruktur und eine von der ersten Leiterstruktur elektrisch isoliert angeordnete zweite Leiterstruktur umfasst, wobei die zweite Leiterstruktur zwischen dem Halbleiterelement und der ersten Leiterstruktur angeordnet ist, wobei der erste Lastkontakt zwischen dem zweiten Lastkontakt und der zweiten Leiterstruktur angeordnet ist, wobei der erste Lastkontakt über zumindest ein erstes Verdrahtungselement mit der ersten Leiterstruktur verbunden ist, wobei der zweite Lastkontakt über zumindest ein zweites Verdrahtungselement mit der zweiten Leiterstruktur verbunden ist, wobei das zweite Verdrahtungselement das erste Verdrahtungselement zumindest teilweise überspannend angeordnet ist.

Ferner wird die Aufgabe erfindungsgemäß gelöst durch Halbleiteranordnung mit einem Halbleiterelement und einem Trägerelement, wobei ein erster Lastkontakt des Halbleiterelements, insbesondere stoffschlüssig, mit einer ersten Leiterstruktur des Trägerelements verbunden ist, wobei das Halbleiterelement auf einer dem Trägerelement abgewandten Seite einen zweiten Lastkontakt aufweist, wobei das Trägerelement ein von der ersten Leiterstruktur elektrisch isoliert angeordnete zweite Leiterstruktur umfasst, wobei der zweite Lastkontakt über zumindest ein zweites Verdrahtungselement mit der zweiten Leiterstruktur verbunden ist, wobei mit der ersten Leiterstruktur ein erstes Verdrahtungselement verbunden ist, wobei das zweite Verdrahtungselement das erste Verdrahtungselement zumindest teilweise überspannend angeordnet ist.

Darüber hinaus wird die Aufgabe erfindungsgemäß gelöst durch eine Halbleiteranordnung mit einem ersten Halbleiterelement und einem zweiten Halbleiterelement, welche auf einem Trägerelement angeordnet sind, wobei das erste Halbleiterelement auf einer dem Trägerelement abgewandten Seite einen ersten Lastkontakt und das zweite Halbleiterelement auf einer dem Trägerelement abgewandten Seite einen zweiten Lastkontakt aufweist, wobei das Trägerelement eine erste Leiterstruktur und ein von der ersten Leiterstruktur elektrisch isoliert angeordnete zweite Leiterstruktur umfasst, wobei die zweite Leiterstruktur zwischen dem Halbleiterelement und der ersten Leiterstruktur angeordnet ist, wobei der erste Lastkontakt über zumindest ein erstes Verdrahtungselement mit der ersten Leiterstruktur verbunden ist, wobei der zweite Lastkontakt über zumindest ein zweites Verdrahtungselement mit der zweiten Leiterstruktur verbunden ist, wobei das zweite Verdrahtungselement das erste Verdrahtungselement zumindest teilweise überspannend angeordnet ist.

Überdies wird die Aufgabe erfindungsgemäß gelöst durch einen Stromrichter mit mindestens einer derartigen Halbleiteranordnung.

Darüber hinaus wird die Aufgabe erfindungsgemäß gelöst durch ein Verfahren zur Herstellung einer Halbleiteranordnung mit einem Halbleiterelement, welches auf einem Trägerelement angeordnet wird, wobei das Halbleiterelement auf einer dem Trägerelement abgewandten Seite einen ersten Lastkontakt und einen zweiten Lastkontakt aufweist, wobei das Trägerelement eine erste Leiterstruktur und eine von der ersten Leiterstruktur elektrisch isoliert angeordnete zweite Leiterstruktur umfasst, wobei die zweite Leiterstruktur zwischen dem Halbleiterelement und der ersten Leiterstruktur angeordnet ist, wobei der erste Lastkontakt zwischen dem zweiten Lastkontakt und der zweiten Leiterstruktur angeordnet ist, wobei der erste Lastkontakt über zumindest ein erstes Verdrahtungselement mit der ersten Leiterstruktur verbunden wird, wobei in einem weiteren Schritt der zweite Lastkontakt über zumindest ein zweites Verdrahtungselement mit der zweiten Leiterstruktur verbunden wird, wobei das zweite Verdrahtungselement das erste Verdrahtungselement zumindest teilweise überspannend angeordnet wird.

Die in Bezug auf die Halbleiteranordnung nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, eine parasitäre Induktivität von Verdrahtungselementen, welche zur Kontaktierung von Halbleiterelementen auf einem Trägerelement, z.B. einem Substrat, verwendet werden, dadurch zu minimieren, dass diese zumindest teilweise überspannend angeordnet werden. Derartige Verdrahtungselemente können beispielsweise Bonddrähte oder Bondbänder sein. Unter einer zumindest teilweise überspannend ausgeführten Anordnung von Verdrahtungselementen ist zu verstehen, dass zumindest ein Verdrahtungselement ein weiteres Verdrahtungselement in einem bestimmten Abstand überlappt, ohne dass sich die Verdrahtungselemente berühren. Insbesondere tritt bei einer überspannend ausgeführten Anordnung eine merkliche magnetische Wechselwirkung zwischen den Verdrahtungselementen auf, sodass sich die parasitären Induktivitäten der Verdrahtungselemente reduzieren, was dazu führt, dass höhere Schaltgeschwindigkeiten, insbesondere bei Verwendung von Halbleiterelementen mit breiter Bandlücke, z.B. GaN- oder SiC- Halbleiterelementen, ermöglicht werden. Durch Anpassen einer Länge und/oder eines Abstandes von Verdrahtungselementen, welche zumindest teilweise überspannend angeordnet sind, können die Induktivitäten flexibel eingestellt werden, was unter anderem zum Ausgleichen von Induktivitäten von parallel geschalteten Chips vorteilhaft ist.

Eine weitere Ausführungsform sieht vor, dass das Halbleiterelement als horizontal leitender Leistungshalbleiter ausgeführt ist. Derartige Leistungshalbleiter können auch als laterale Leistungshalbleiter bezeichnet werden. Unter anderem Leistungshalbleiter mit breiter Bandlücke, insbesondere GaN-Leistungshalbleiter können als horizontal leitende Leistungshalbleiter ausgeführt sein. Derartige laterale Leistungshalbleiter können auf einer Oberfläche zwei Lastkontakte, z.B. einen Drain-Kontakt und einen Source-Kontakt aufweisen. Werden Verdrahtungselemente zur Verbindung beider Lastkontakte mit einem Trägerelement, insbesondere parallel, in dieselbe Richtung geführt, sodass eine zumindest teilweise überspannend ausgeführten Anordnung der Verdrahtungselemente der beiden Lastkontakte vorliegt, wird eine parasitäre Induktivität der Verdrahtung reduziert. Ferner wird ein platzsparendes Schaltungslayout ermöglicht.

Eine weitere Ausführungsform sieht vor, dass der erste Lastkontakt über eine Mehrzahl von ersten Verdrahtungselementen mit der ersten Leiterstruktur verbunden ist, wobei der zweite Lastkontakt über eine Mehrzahl von zweiten Verdrahtungselementen mit der zweiten Leiterstruktur verbunden ist, wobei die zweiten Verdrahtungselemente die ersten Verdrahtungselemente zumindest teilweise überspannend angeordnet sind. Durch die Verwendung einer Mehrzahl von Verdrahtungselementen wird die Stromtragfähigkeit erhöht und die parasitäre Induktivität reduziert.

Eine weitere Ausführungsform sieht vor, dass die ersten Verdrahtungselemente und die zweiten Verdrahtungselemente jeweils parallel zueinander verlaufend angeordnet sind. Durch eine derartige parallele Anordnung lassen sich die Abstände zwischen den Verdrahtungselementen optimieren, sodass sich die parasitären Induktivitäten reduzieren und Bauraum eingespart wird.

Eine weitere Ausführungsform sieht vor, dass die ersten Verdrahtungselemente in einer senkrechten Projektion der zweiten Verdrahtungselemente auf eine Oberfläche des Trägerelements angeordnet sind. Somit sind die ersten Verdrahtungselemente, bezogen auf die Oberfläche des Trägerelements, parallel senkrecht übereinander angeordnet, sodass eine optimierte Reduzierung der parasitären Induktivitäten stattfindet.

Eine weitere Ausführungsform sieht vor, dass ein erster Stromfluss durch das ersten Verdrahtungselement gegenläufig zu einem zweiten Stromfluss durch das zweiten Verdrahtungselemente erfolgt. Dies hat den Effekt, dass sich die Magnetfelder der Verdrahtungselemente ausgleichen bzw. kompensieren.

Eine weitere Ausführungsform sieht vor, dass ein Abstand zwischen einem ersten Verdrahtungselement und einem zweiten Verdrahtungselement mindestens 200 um, insbesondere mindestens 500 µm, beträgt. Derartige Abstände führen zu einer optimierten Reduzierung der parasitären Induktivitäten und bieten eine ausreichende Robustheit gegen Überspannungsspitzen.

Eine weitere Ausführungsform sieht vor, dass zwischen zumindest einem ersten Verdrahtungselement und zumindest einem zweiten Verdrahtungselement ein Isolationselement angeordnet ist. Das Isolationselement kann unter anderem eine elektrisch isolierende Folie sein. Ein derartiges Isolationselement definiert einen Mindestabstand und bietet eine ausreichende Robustheit gegen Überspannungsspitzen.

Eine weitere Ausführungsform sieht vor, dass die erste Leiterstruktur und die zweite Leiterstruktur jeweils mindestens zwei Finger umfassen, die in einer Kammform angeordnet sind, wobei erste Finger der ersten Leiterstruktur und zweite Finger der zweiten Leiterstruktur ineinandergreifend angeordnet sind. Durch eine derartige Anordnung wird Bauraum eingespart.

Eine weitere Ausführungsform sieht vor, dass die Halbleiteranordnung mindestens zwei Halbleiterelemente aufweist, wobei die Halbleiterelemente jeweils, insbesondere stoffschlüssig, mit einem ersten Finger der ersten Leiterstruktur verbunden sind, wobei die zweiten Lastkontakte von jeweils zwei Halbleiterelementen über zweite Verdrahtungselemente mit einem gemeinsamen zweiten Finger der zweiten Leiterstruktur verbunden sind. Die stoffschlüssige Verbindung ist unter anderem durch Löten oder Sintern herstellbar. Über den gemeinsamen zweiten Finger fließt ein gemeinsamer Summen-Laststrom der zwei Halbleiterelemente, sodass die benötigte Fläche der Halbleiteranordnung reduziert wird.

Im Folgenden wird die Erfindung anhand der in den Figuren dargestellten Ausführungsbeispiele näher beschrieben und erläutert.

Es zeigen:
- FIG 1: eine schematische dreidimensionale Darstellung einer ersten Ausführungsform einer Halbleiteranordnung in einer Seitenansicht,
- FIG 2: eine schematische dreidimensionale Darstellung einer zweiten Ausführungsform einer Halbleiteranordnung in einer Seitenansicht,
- FIG 3: eine schematische dreidimensionale Darstellung einer dritten Ausführungsform einer Halbleiteranordnung in einer Draufsicht,
- FIG 4: eine schematische Darstellung einer vierten Ausführungsform einer Halbleiteranordnung in einer Draufsicht,
- FIG 5: eine schematische dreidimensionale Darstellung einer fünften Ausführungsform einer Halbleiteranordnung in einer Seitenansicht,
- FIG 6: eine schematische dreidimensionale Darstellung einer sechsten Ausführungsform einer Halbleiteranordnung in einer Seitenansicht,
- FIG 7: eine schematische dreidimensionale Darstellung einer siebten Ausführungsform einer Halbleiteranordnung in einer Seitenansicht,
- FIG 8: eine schematische dreidimensionale Darstellung einer achten Ausführungsform einer Halbleiteranordnung in einer Draufsicht,
- FIG 9: eine schematische dreidimensionale Darstellung der achten Ausführungsform einer Halbleiteranordnung in einer Seitenansicht und
- FIG 10: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

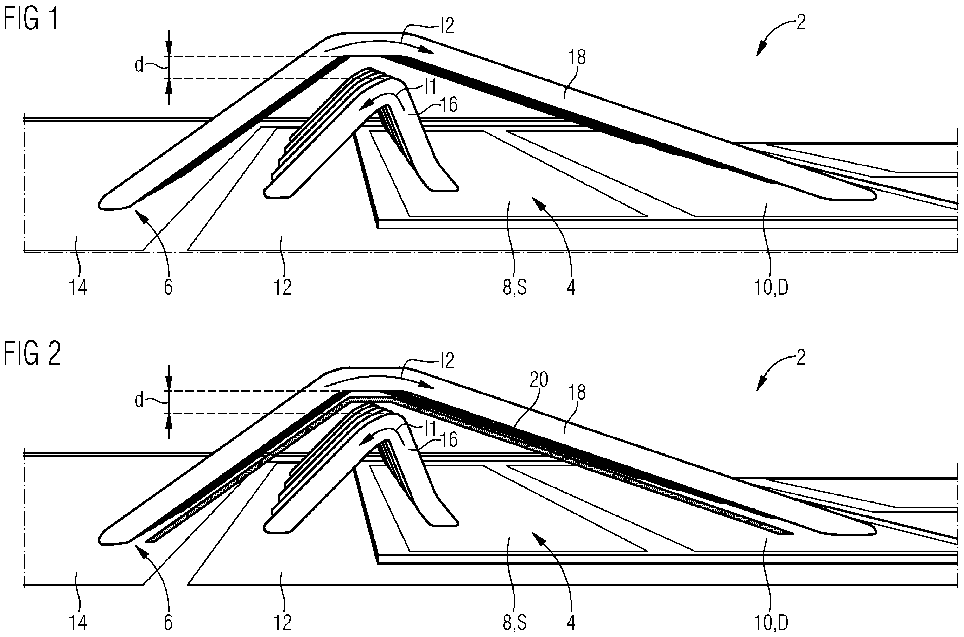

FIG 1 zeigt eine schematische dreidimensionale Darstellung einer ersten Ausführungsform einer Halbleiteranordnung 2 in einer Seitenansicht, welche ein Halbleiterelement 4 umfasst, das auf einem Trägerelement 6 kontaktiert ist. Beispielhaft ist das Halbleiterelement 4 als ein horizontal leitender Leistungshalbleiter mit breiter Bandlücke, insbesondere als GaN-HEMT (Galliumnitrid High Electron-Mobility Transistor) ausgeführt. Ein horizontal leitender Leistungshalbleiter kann auch als lateraler Leistungshalbleiter bezeichnet werden. Das Trägerelement 6 ist beispielhaft als DCB(direct copper bonded)-Substrat ausgeführt. Der horizontal leitende Leistungshalbleiter ist stoffschlüssig, z.B. durch Löten oder Sintern, auf dem DCB-Substrat verbunden und umfasst auf einer dem DCB-Substrat abgewandten Seite einen ersten Lastkontakt 8 und einen zweiten Lastkontakt 10. Der erste Lastkontakt 8 ist als Source-Kontakt S und der zweite Lastkontakt 10 ist als Drain-Kontakt D des als GaN-HEMT ausgeführten Halbleiterelements 4 ausgeführt.

Das Trägerelement 6 weist eine erste Leiterstruktur 12 und eine von der ersten Leiterstruktur 12 elektrisch isoliert angeordnete zweite Leiterstruktur 14 auf, wobei die zweite Leiterstruktur 14 zwischen dem Halbleiterelement 4 und der ersten Leiterstruktur 12 angeordnet ist. Die Leiterstrukturen 12, 14 sind beispielsweise als Kupferkaschierung eines DCB-Substrats ausgeführt.

Der erste Lastkontakt 8 bzw. der Source-Kontakt S ist über eine Mehrzahl von ersten Verdrahtungselementen 16 mit der ersten Leiterstruktur 12 verbunden, während der zweite Lastkontakt 10 über eine Mehrzahl von zweiten Verdrahtungselementen 18 mit der zweiten Leiterstruktur 14 verbunden ist. Die Verdrahtungselemente 16, 18 können unter anderem als aus Aluminium, Gold, Kupfer oder Silber hergestellte Bonddrähte oder Bondbänder ausgeführt sein. Die Verbindung der Verdrahtungselemente 16, 18 erfolgt stoffschlüssig, beispielsweise mittels Drahtbonden. Die ersten Verdrahtungselemente 16 und die zweiten Verdrahtungselemente 18 sind jeweils parallel zueinander verlaufend angeordnet. Ferner sind die zweiten Verdrahtungselemente 18 derartig angeordnet, dass diese die ersten Verdrahtungselemente 16 überspannen. Ein Abstand d zwischen den ersten Verdrahtungselementen 16 und den zweiten Verdrahtungselementen 18 beträgt mindestens 200 µm, insbesondere mindestens 500 µm. Die Luftstrecke ist kleiner als die Kriechstrecke auf der Chipoberfläche. Die Verdrahtungselemente 16, 18 können in einer geraden Linie oder mit einem kleinen Bondwinkel verbunden werden. Durch die Überlappung der ersten Verdrahtungselemente 16 durch die zweiten Verdrahtungselemente 18 wird die parasitäre Induktivität verringert. Außerdem erfolgt ein erster Stromfluss I1 durch das erste Verdrahtungselement 16 gegenläufig zu einem zweiten Stromfluss I2 durch das zweite Verdrahtungselement 18, sodass sich die Magnetfelder ausgleichen bzw. kompensieren.

FIG 2 zeigt eine schematische dreidimensionale Darstellung einer zweiten Ausführungsform einer Halbleiteranordnung 2 in einer Seitenansicht, wobei zwischen den ersten Verdrahtungselementen 16 und den zweiten Verdrahtungselementen 18 ein Isolationselement 20 angeordnet ist. Das Isolationselement 20 kann unter anderem eine elektrisch isolierende Folie sein. Die weitere Ausführung der Halbleiteranordnung 2 in FIG 2 entspricht der Ausführung in FIG 1.

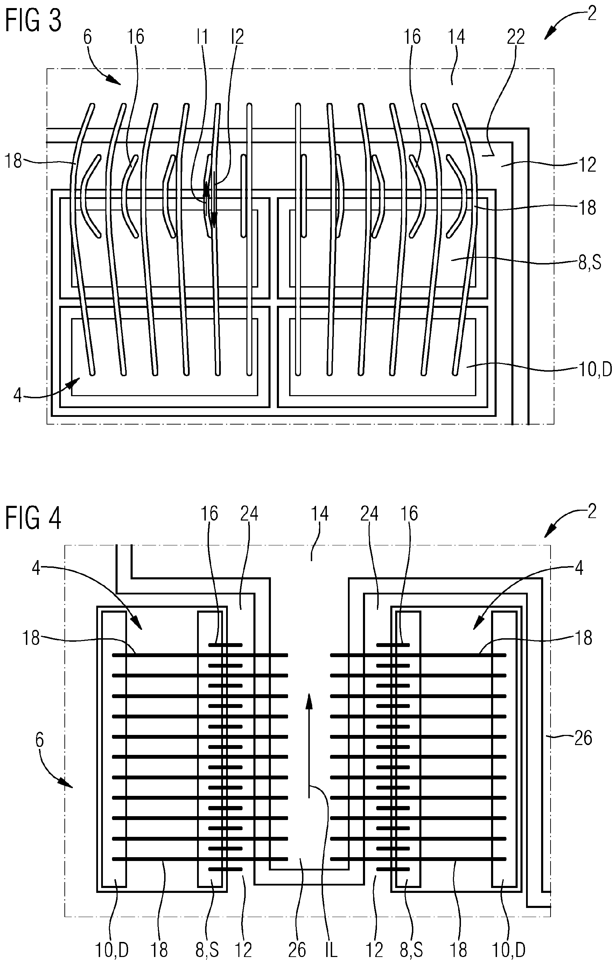

FIG 3 zeigt eine schematische dreidimensionale Darstellung einer dritten Ausführungsform einer Halbleiteranordnung 2 in einer Draufsicht. Die ersten Verdrahtungselemente 16 sind in einer senkrechten Projektion der zweiten Verdrahtungselemente 18 auf eine Oberfläche 22 des Trägerelements 6 angeordnet.

Alternativ können ersten Verdrahtungselemente 16 und die zweiten Verdrahtungselemente 18 alternierend, insbesondere äquidistant, angeordnet sein. Die weitere Ausführung der Halbleiteranordnung 2 in FIG 3 entspricht der Ausführung in FIG 1.

FIG 4 zeigt eine schematische Darstellung einer vierten Ausführungsform einer Halbleiteranordnung 2 in einer Draufsicht, wobei die erste Leiterstruktur 12 und die zweite Leiterstruktur 14 Finger 24, 26 umfassen, die in einer Kammform angeordnet sind. Der erste Finger 24 der ersten Leiterstruktur 12 und zweite Finger 26 der zweiten Leiterstruktur 14 sind ineinandergreifend angeordnet. Ferner umfasst die Halbleiteranordnung 2 mindestens zwei Halbleiterelemente 4, die als horizontal leitende Leistungshalbleiter mit breiter Bandlücke, insbesondere als GaN-HEMT (Galliumnitrid High Electron-Mobility Transistor) ausgeführt und jeweils stoffschlüssig mit einem der ersten Finger 24 verbunden sind. Die zweiten Lastkontakte 10 von jeweils zwei Halbleiterelementen 4 sind über zweite Verdrahtungselemente 18 mit einem gemeinsamen zweiten Finger 26 der zweiten Leiterstruktur 14 verbunden. Ein gemeinsamer Laststrom IL der zwei Halbleiterelemente 4 fließt über den gemeinsamen zweiten Finger 26, sodass die benötigte Fläche der Halbleiteranordnung 2 reduziert wird. Die weitere Ausführung der Halbleiteranordnung 2 in FIG 4 entspricht der Ausführung in FIG 3.

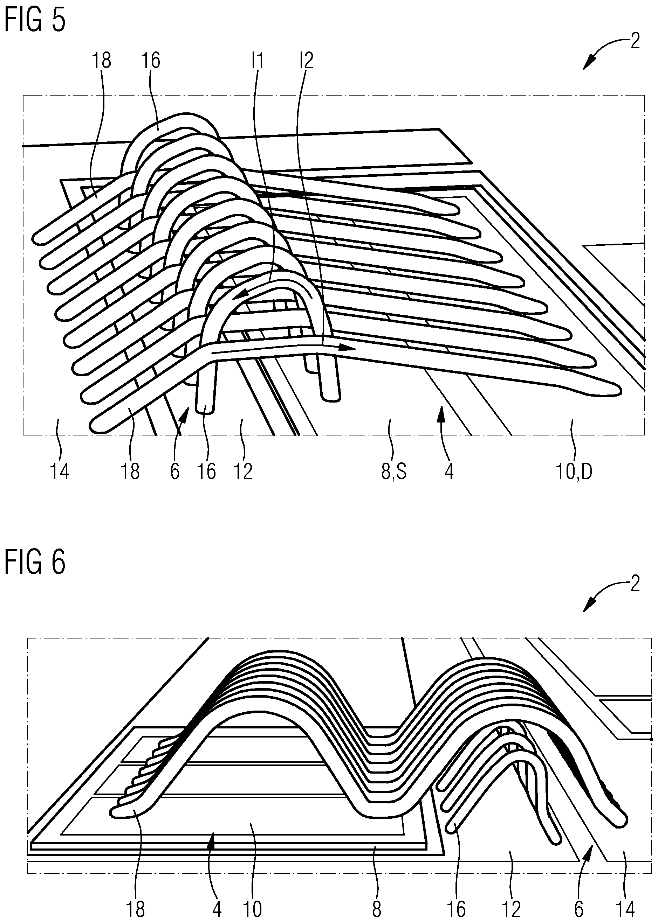

FIG 5 zeigt eine schematische dreidimensionale Darstellung einer fünften Ausführungsform einer Halbleiteranordnung in einer Seitenansicht. Die zweiten Verdrahtungselemente 18 überspannen die ersten Verdrahtungselemente 16 teilweise, während die ersten Verdrahtungselemente 16 teilweise über die zweiten Verdrahtungselemente 18 hinausstehen, sodass sich die Verdrahtungselemente 16, 18 jeweils zwei Mal kreuzen. Die weitere Ausführung der Halbleiteranordnung 2 in FIG 5 entspricht der Ausführung in FIG 1.

FIG 6 zeigt eine schematische dreidimensionale Darstellung einer sechsten Ausführungsform einer Halbleiteranordnung 2 in einer Seitenansicht, wobei das Halbleiterelement 4 als vertikaler Leistungshalbleiter, insbesondere als vertikaler SiC(Siliziumkarbid)-Leistungstransistor oder als IGBT(Insulated Gate Bipolar Transistor) ausgeführt ist. Das Trägerelement 6, das beispielhaft als DCB(direct copper bonded)-Substrat ausgeführt ist, weist eine erste Leiterstruktur 12 und eine von der ersten Leiterstruktur 12 elektrisch isoliert angeordnete zweite Leiterstruktur 14 auf. Ein erster Lastkontakt 8 des Halbleiterelements 4 ist stoffschlüssig, z.B. durch Löten oder Sintern, mit der ersten Leiterstruktur 12 verbunden. Ferner weist das Halbleiterelement 4 auf einer dem Trägerelement 6 abgewandten Seite einen zweiten Lastkontakt 10 auf, der über zumindest ein zweites Verdrahtungselement 18 mit der zweiten Leiterstruktur 14 verbunden ist. Ein erstes Verdrahtungselement 16 ist mit der ersten Leiterstruktur 12 verbunden, welches eine über die erste Leiterstruktur 12 kurzgeschlossene und somit stromlose Leiterschleife ausbildet. Das zweite Verdrahtungselement 18 überspannt die Leiterschleife des ersten Verdrahtungselements 16, welche zumindest teilweise an die Form des zweiten Verdrahtungselements 18 angepasst ist. Durch Anpassen der Leiterschleife kann die Induktivität des zweiten Verdrahtungselements 18 eingestellt werden, was unter anderem zum Ausgleichen einer Induktivität von parallel geschalteten Chips genutzt werden kann. Die weitere Ausführung der Halbleiteranordnung 2 in FIG 6 entspricht der Ausführung in FIG 1.

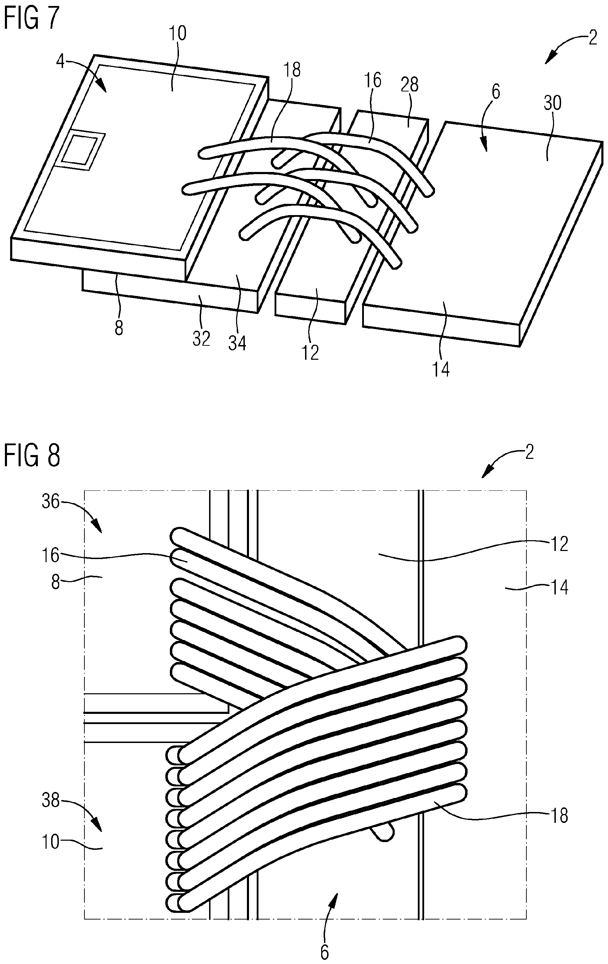

FIG 7 zeigt eine schematische dreidimensionale Darstellung einer siebten Ausführungsform einer Halbleiteranordnung in einer Seitenansicht, wobei das Halbleiterelement 4 als vertikaler Leistungshalbleiter ausgeführt ist. Das Trägerelement 6 umfasst ein erstes Substrat 28 mit einer ersten Leiterstruktur 12, ein zweites Substrat 30 mit einer zweiten Leiterstruktur 14 und ein drittes Substrat 32 mit einer dritten Leiterstruktur 34. Ein erster Lastkontakt 8 des Halbleiterelements 4 ist stoffschlüssig, z.B. durch Löten oder Sintern, mit der dritten Leiterstruktur 34 des dritten Substrats 32 verbunden. Ferner weist das Halbleiterelement 4 auf einer dem Trägerelement 6 abgewandten Seite einen zweiten Lastkontakt 10 auf, der über zweite Verdrahtungselemente 18 mit der zweiten Leiterstruktur 14 des zweiten Substrats 30 verbunden ist. Der erste Lastkontakt 8 des Halbleiterelements 4 ist über erste Verdrahtungselemente 16, welche mit der dritten Leiterstruktur 34 des dritten Substrats 32 verbunden sind, mit der zweiten Leiterstruktur 14 des zweiten Substrats 30 verbunden. Die Verdrahtungselemente 16, 18 sind alternierend angeordnet. Darüber hinaus überspannen die zweiten Verdrahtungselemente 18 die ersten Verdrahtungselemente 16 teilweise, während die ersten Verdrahtungselemente 16 teilweise über die zweiten Verdrahtungselemente 18 hinausstehen, sodass sich die Verdrahtungselemente 16, 18 jeweils einmal unter Einhaltung eines bestimmten Abstands kreuzen. Die weitere Ausführung der Halbleiteranordnung 2 in FIG 5 entspricht der Ausführung in FIG 6.

FIG 8 zeigt eine schematische dreidimensionale Darstellung einer achten Ausführungsform einer Halbleiteranordnung 2 in einer Draufsicht, die ein erstes Halbleiterelement 36 und ein zweites Halbleiterelement 38 umfasst. Die Halbleiterelemente 36, 38, welche als vertikaler Leistungshalbleiter ausgeführt sind, sind auf einem gemeinsamen Trägerelement 6 angeordnet, wobei das erste Halbleiterelement 36 auf einer dem Trägerelement 6 abgewandten Seite einen ersten Lastkontakt 8 und das zweite Halbleiterelement 38 auf einer dem Trägerelement 6 abgewandten Seite einen zweiten Lastkontakt 10 aufweist. Das Trägerelement 6, das beispielhaft als DCB(direct copper bonded)-Substrat ausgeführt ist, weist eine erste Leiterstruktur 12 und eine von der ersten Leiterstruktur 12 elektrisch isoliert angeordnete zweite Leiterstruktur 14 auf. Die erste Leiterstruktur 12 ist zwischen den Halbleiterelementen 36, 38 und der zweiten Leiterstruktur 14 angeordnet. Der erste Lastkontakt 8 ist über erste Verdrahtungselemente 16 mit der ersten Leiterstruktur 12 verbunden, wobei der zweite Lastkontakt 10 über zweite Verdrahtungselemente 18 mit der zweiten Leiterstruktur 14 verbunden ist. Die im Wesentlichen parallel verlaufend angeordneten zweiten Verdrahtungselemente 18 überspannen die im Wesentlichen parallel verlaufend angeordneten ersten Verdrahtungselemente 16 teilweise. Die erste Leiterstruktur 12 und die zweite Leiterstruktur 14 können, wie in FIG 7 gezeigt, auf unterschiedlichen Substraten 28, 30 angeordnet sein. Die weitere Ausführung der Halbleiteranordnung 2 in FIG 5 entspricht der Ausführung in FIG 1.

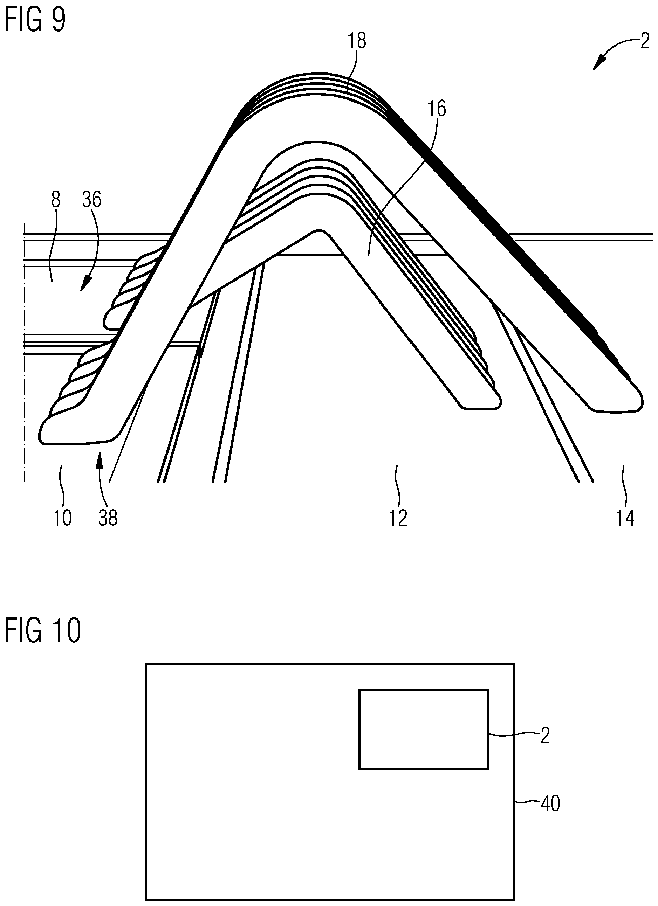

FIG 9 zeigt eine schematische dreidimensionale Darstellung der achten Ausführungsform einer Halbleiteranordnung 2, welche in FIG 8 gezeigt ist, in einer Seitenansicht.

FIG 10 zeigt eine schematische Darstellung eines Stromrichters 40 mit einer Halbleiteranordnung 2. Der Stromrichter 40 kann mehr als eine Halbleiteranordnung 2 umfassen.

Zusammenfassend betrifft die Erfindung eine Halbleiteranordnung 2 mit einem Halbleiterelement 4, welches auf einem Trägerelement 6 angeordnet ist, wobei das Halbleiterelement 4 auf einer dem Trägerelement 6 abgewandten Seite einen ersten Lastkontakt 8 und einen zweiten Lastkontakt 10 aufweist, wobei das Trägerelement 6 eine erste Leiterstruktur 12 und eine von der ersten Leiterstruktur 12 elektrisch isoliert angeordnete zweite Leiterstruktur 14 umfasst.

Um, im Vergleich zum Stand der Technik, eine verbesserte Verdrahtung anzugeben wird vorgeschlagen, dass die zweite Leiterstruktur 14 zwischen dem Halbleiterelement 4 und der ersten Leiterstruktur 12 angeordnet ist, wobei der erste Lastkontakt 8 zwischen dem zweiten Lastkontakt 10 und der zweiten Leiterstruktur 14 angeordnet ist, wobei der erste Lastkontakt 8 über zumindest ein erstes Verdrahtungselement 16 mit der ersten Leiterstruktur 12 verbunden ist, wobei der zweite Lastkontakt 10 über zumindest ein zweites Verdrahtungselement 18 mit der zweiten Leiterstruktur 14 verbunden ist, wobei das zweite Verdrahtungselement 18 das erste Verdrahtungselement 16 zumindest teilweise überspannend angeordnet ist.

## Patentansprüche

1. Halbleiteranordnung (2) mit einem Halbleiterelement (4), welches auf einem Trägerelement (6) angeordnet ist,
wobei das Halbleiterelement (4) auf einer dem Trägerelement (6) abgewandten Seite einen ersten Lastkontakt (8) und einen zweiten Lastkontakt (10) aufweist,
wobei das Trägerelement (6) eine erste Leiterstruktur (12) und eine von der ersten Leiterstruktur (12) elektrisch isoliert angeordnete zweite Leiterstruktur (14) umfasst,
wobei die zweite Leiterstruktur (14) zwischen dem Halbleiterelement (4) und der ersten Leiterstruktur (12) angeordnet ist,
wobei der erste Lastkontakt (8) zwischen dem zweiten Lastkontakt (10) und der zweiten Leiterstruktur (14) angeordnet ist, wobei der erste Lastkontakt (8) über zumindest ein erstes Verdrahtungselement (16) mit der ersten Leiterstruktur (12) verbunden ist,
wobei der zweite Lastkontakt (10) über zumindest ein zweites Verdrahtungselement (18) mit der zweiten Leiterstruktur (14) verbunden ist,
wobei das zweite Verdrahtungselement (18) das erste Verdrahtungselement (16) zumindest teilweise überspannend angeordnet ist.

2. Halbleiteranordnung (2) nach Anspruch 1,
wobei das Halbleiterelement (4) als horizontal leitender Leistungshalbleiter ausgeführt ist.

3. Halbleiteranordnung (2) nach einem der Ansprüche 1 oder 2, wobei der erste Lastkontakt (8) über eine Mehrzahl von ersten Verdrahtungselementen (16) mit der ersten Leiterstruktur (12) verbunden ist,
wobei der zweite Lastkontakt (10) über eine Mehrzahl von zweiten Verdrahtungselementen (18) mit der zweiten Leiterstruktur (14) verbunden ist,
wobei die zweiten Verdrahtungselemente (18) die ersten Verdrahtungselemente (16) zumindest teilweise überspannend angeordnet sind.

4. Halbleiteranordnung (2) nach Anspruch 3,
wobei die ersten Verdrahtungselemente (16) und die zweiten Verdrahtungselemente (18) jeweils parallel zueinander verlaufend angeordnet sind.

5. Halbleiteranordnung (2) nach einem der Ansprüche 3 oder 4, wobei die ersten Verdrahtungselemente (16) in einer senkrechten Projektion der zweiten Verdrahtungselemente (18) auf eine Oberfläche (22) des Trägerelements (6) angeordnet sind.

6. Halbleiteranordnung (2) nach einem der Ansprüche 3 oder 4, wobei ein erster Stromfluss (I1) durch das erste Verdrahtungselement (16) gegenläufig zu einem zweiten Stromfluss (12) durch das zweite Verdrahtungselement (18) erfolgt.

7. Halbleiteranordnung (2) nach einem der vorherigen Ansprüche,
wobei ein Abstand (d) zwischen einem ersten Verdrahtungselement (16) und einem zweiten Verdrahtungselement (18) mindestens 200 µm, insbesondere mindestens 500 µm, beträgt.

8. Halbleiteranordnung (2) nach einem der vorherigen Ansprüche,
wobei zwischen zumindest einem ersten Verdrahtungselement (16) und zumindest einem zweiten Verdrahtungselement (18) ein Isolationselement (20) angeordnet ist.

9. Halbleiteranordnung (2) nach einem der vorherigen Ansprüche,
wobei die erste Leiterstruktur (12) und die zweite Leiterstruktur (14) jeweils mindestens zwei Finger (24, 26) umfassen, die in einer Kammform angeordnet sind,
wobei erster Finger (24) der ersten Leiterstruktur (12) und zweiter Finger (26) der zweiten Leiterstruktur (14) ineinandergreifend angeordnet sind.

10. Halbleiteranordnung (2) nach Anspruch 9,
aufweisend mindestens zwei Halbleiterelemente (4),
wobei die Halbleiterelemente (4) jeweils, insbesondere stoffschlüssig, mit einem ersten Finger (24) der ersten Leiterstruktur (12) verbunden sind,
wobei die zweiten Lastkontakte (10) von jeweils zwei Halbleiterelementen (4) über zweite Verdrahtungselemente (18) mit einem gemeinsamen zweiten Finger (26) der zweiten Leiterstruktur (14) verbunden sind.

11. Halbleiteranordnung (2) mit einem Halbleiterelement (4) und einem Trägerelement (6),
wobei ein erster Lastkontakt (8) des Halbleiterelements (4), insbesondere stoffschlüssig, mit einer ersten Leiterstruktur (12) des Trägerelements (6) verbunden ist,
wobei das Halbleiterelement (4) auf einer dem Trägerelement (6) abgewandten Seite einen zweiten Lastkontakt (10) aufweist,
wobei das Trägerelement (6) ein von der ersten Leiterstruktur (12) elektrisch isoliert angeordnete zweite Leiterstruktur (14) umfasst,
wobei der zweite Lastkontakt (10) über zumindest ein zweites Verdrahtungselement (18) mit der zweiten Leiterstruktur (14) verbunden ist,
wobei mit der ersten Leiterstruktur (12) ein erstes Verdrahtungselement (16) verbunden ist,
wobei das zweite Verdrahtungselement (18) das erste Verdrahtungselement (16) zumindest teilweise überspannend angeordnet ist.

12. Halbleiteranordnung (2) nach Anspruch 11,
wobei das Halbleiterelement (4) als vertikaler Leistungshalbleiter ausgeführt ist.

13. Halbleiteranordnung (2) nach einem der Ansprüche 11 oder 12,
wobei der zweite Lastkontakt (10) über eine Mehrzahl von zweiten Verdrahtungselementen (18) mit der zweiten Leiterstruktur (12) verbunden ist,
wobei auf der ersten Leiterstruktur (12) eine Mehrzahl von ersten Verdrahtungselementen (16) kontaktiert ist,
wobei die zweiten Verdrahtungselemente (18) die ersten Verdrahtungselemente (16) zumindest teilweise überspannend angeordnet sind.

14. Halbleiteranordnung (2) nach einem der Ansprüche 11 bis 13,
wobei ein zweites Verdrahtungselement (18) ein erstes Verdrahtungselement (16) kreuzt.

15. Halbleiteranordnung (2) mit einem ersten Halbleiterelement (36) und einem zweiten Halbleiterelement (38), welche auf einem Trägerelement (6) angeordnet sind,
wobei das erste Halbleiterelement (36) auf einer dem Trägerelement (6) abgewandten Seite einen ersten Lastkontakt (8) und das zweite Halbleiterelement (38) auf einer dem Trägerelement (6) abgewandten Seite einen zweiten Lastkontakt (10) aufweist,
wobei das Trägerelement (6) eine erste Leiterstruktur (12) und eine von der ersten Leiterstruktur (12) elektrisch isoliert angeordnete zweite Leiterstruktur (14) umfasst,
wobei die erste Leiterstruktur (12) zwischen den Halbleiterelementen (36, 38) und der zweiten Leiterstruktur (14) angeordnet ist,
wobei der erste Lastkontakt (8) über zumindest ein erstes Verdrahtungselement (16) mit der ersten Leiterstruktur (12) verbunden ist,
wobei der zweite Lastkontakt (10) über zumindest ein zweites Verdrahtungselement (18) mit der zweiten Leiterstruktur (14) verbunden ist,
wobei das zweite Verdrahtungselement (18) das erste Verdrahtungselement (16) zumindest teilweise überspannend angeordnet ist.

16. Halbleiteranordnung (2) nach Anspruch 11,
wobei die Halbleiterelemente (36, 38) als vertikaler Leistungshalbleiter ausgeführt sind.

17. Halbleiteranordnung (2) nach einem der Ansprüche 15 oder 16,
wobei der erste Lastkontakt (8) über eine Mehrzahl von ersten Verdrahtungselementen (16) mit der ersten Leiterstruktur (12) verbunden ist,
wobei der zweite Lastkontakt (10) über eine Mehrzahl von zweiten Verdrahtungselementen (18) mit der zweiten Leiterstruktur (14) verbunden ist,
wobei die zweiten Verdrahtungselemente (18) die ersten Verdrahtungselemente (16) zumindest teilweise überspannend angeordnet sind.

18. Stromrichter (40) mit mindestens einer Halbleiteranordnung (2) nach einem der vorherigen Ansprüche.

19. Verfahren zur Herstellung einer Halbleiteranordnung (2) mit einem Halbleiterelement (4), welches auf einem Trägerelement (6) angeordnet wird,
wobei das Halbleiterelement (4) auf einer dem Trägerelement (6) abgewandten Seite einen ersten Lastkontakt (8) und einen zweiten Lastkontakt (10) aufweist,
wobei das Trägerelement (6) eine erste Leiterstruktur (12) und eine von der ersten Leiterstruktur (12) elektrisch isoliert angeordnete zweite Leiterstruktur (14) umfasst,
wobei die zweite Leiterstruktur (14) zwischen dem Halbleiterelement (4) und der ersten Leiterstruktur (12) angeordnet ist,
wobei der erste Lastkontakt (8) zwischen dem zweiten Lastkontakt (10) und der zweiten Leiterstruktur (14) angeordnet ist, wobei der erste Lastkontakt (8) über zumindest ein erstes Verdrahtungselement (16) mit der ersten Leiterstruktur (12) verbunden wird,
wobei in einem weiteren Schritt der zweite Lastkontakt (10) über zumindest ein zweites Verdrahtungselement (18) mit der zweiten Leiterstruktur (14) verbunden wird,
wobei das zweite Verdrahtungselement (18) das erste Verdrahtungselement (16) zumindest teilweise überspannend angeordnet wird.
